# EUROPEAN PATENT APPLICATION

(11) **EP 2 779 301 A1**
(43) Date of publication of application: **17.09.2014**
(21) Application number: 14000981.2
(22) Date of filing: 17.03.2014
(51) Int. Cl.: H01M 10/42, H01M 10/48, H01M 2/20

(54) **Improved battery electrolyte level monitor**

(30) Priority: 15.03.2013 US 201361790902 P
(71) Applicant: Jones, Duncan, Manchester MI 5JW (GB); Worthington, John, Rochdale, Lancashire OL11 5AA (GB); Philadelphia Scientific LLC, Montgomeryville, PA 18936 (US)
(72) Inventor: JONES, Duncan, MI 5JW Manchester (GB); WORTHINGTON, John, OL11 5AA Lancashire (GB)
(74) Representative: Callies, Rainer Michael

(57) **Abstract**

Improvements to industrial battery monitoring devices include improved circuitry to make the device polarity insensitive and to allow it to operate over a wide range of battery voltages.

## Description

### Reference to Related Application

This is a non-provisional application claiming priority to provisional application U.S. 61/790,902 filed 15 March 2013, which is hereby incorporated herein by reference.

### Background of the Invention

Industrial batteries are expensive devices and it is important to carefully monitor them to ensure they are maintained and used correctly. For example, it is desirable to monitor the electrolyte level in a battery as damage to the battery could occur if the electrolyte level falls too low. Because batteries vary in design, it is presently not possible to find a single monitoring device that is able to be installed easily and without error on every different type of battery. As a result, there are a vast number of product variants required to cover the installation of monitors on the varied battery types.

One significant problem is the difficulty of installing correctly the battery monitoring devices. Since the monitoring devices draw their power from the batteries being monitored, proper installation is critical in achieving proper operation of the devices. As the devices will operate correctly only when provided with voltage within a specific range, care must be taken when choosing the correct locations on the battery for the electrical connections.

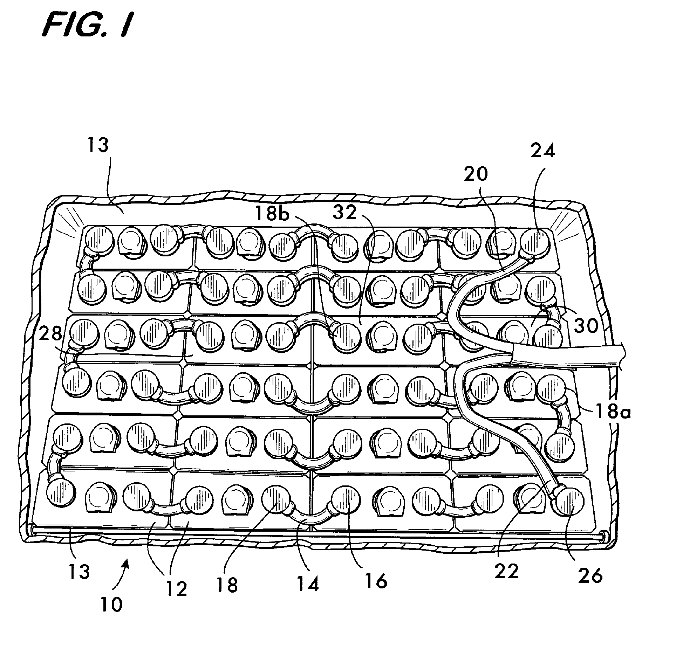

Illustrated in Figure 1 is a typical battery 10 having a plurality of individual cells 12, providing generally about 2 volts per cell, resting within a tray 13. The cells are connected serially via intercell connectors 14 from the positive post 16 of one cell to the negative post 18 of the next cell to provide the total output voltage of the battery 10, usually in the range of 12v to 120v depending on the number of cells and state of charge. The battery 10 illustrated in Fig. 1 contains 24 cells 12 connected in series to provide a total of 48 volts. The battery 10 is connected to positive and negative cables 20, 22 at the positive and negative terminals 24, 26 for connection to the load and battery charger (terminal 24 being the positive terminal).

Current prior art electrolyte level monitoring devices require that the electrolyte probe be installed in one of the cells of the battery 10, and then the positive and negative leads of the monitoring device be connected across the correct number of cells to obtain the voltage required to properly run the device. As an example, with further reference to Fig. 1, the probe of a battery electrolyte level monitor would preferably be installed in a centrally located cell, such as the cell 28. Six cells in series of the battery's 24 cells will be used to provide 12 volts (each cell provides about 2 volts). The device includes a conventional voltage regulator to regulate the voltage down to the 5 volts required to run the device; this is done since the battery's voltage can vary due to charging and discharging of the battery 10. To connect to power, the negative and positive leads of the monitoring device will be connected across six cells to obtain the desired 12 volts.

As one example of the installation of a prior art device, after installing the probe in the desired cell 28, to install the negative lead of the device, the installer will count back 2 cells in the negative direction from the probe cell 28, and connect the negative lead (black wire) to the negative post 18a of that cell - here cell 30, via a screw connector as known in the art. For the positive lead, the installer will count six cells in the opposite direction from the negative connection just made and connect the positive lead (red wire) of the device to the negative post 18b of that cell - here cell 32, to provide approximately 12 volts from the six cells (when the cells are fully charged). As noted above, the monitoring device includes a conventional voltage regulator to regulate the voltage to the range needed for operation of the device as the battery discharges.

There are at least two main points of failure in the present installation method described above. First, the installer may misunderstand or be unaware of the polarity of the battery 10 and install the device electrically backwards, causing the device to fail. Second, the installer may connect the positive and negative leads of the device across the incorrect number of cells, such as by miscounting or simple error, also causing failure. Although these devices have conventional voltage regulators, these are limited in their ability handle wide variations in voltage.

This complicated procedure for choosing the right connection points for the leads of the devices results in a very high rate of installation failure. When dealers install the devices the failure rate can be over 15% or more. When end users perform the installation themselves, failure rates can exceed 90%. As improper installation can result in the destruction of the device, the current design can result in a very high rate of return of the device and is a significant warranty issue. Moreover, because the installation can be complicated, many end customers choose not to purchase such products. Therefore, there is an acutely felt need in the industry to provide a device having a more fool proof method of installation.

### Summary of the Invention

The present invention addresses the problems noted in the background and provides a battery monitoring device having a fool proof method of installation. First, the improved device contains circuitry making it polarity neutral. That is, the device may be installed either way, without regard to which lead of the device is attached to a positive terminal of the battery and which lead of the device is attached to a negative terminal of the battery.

The device also contains circuitry that allows it to be connected to the main leads of the battery, without regard to the number of cells away from the point of installation of the probe. This allows the device to be installed on the main terminals of the battery (i.e., the same terminals to which the powered machinery or load is connected), eliminating to need to count the number of cells to obtain the correct voltage. This improvement has the further advantage of allowing the use of a single model of the device with batteries having any output voltage.

A novel combination of a battery and the monitoring device is also provided.

Other improvements are also provided. For example, the device can be equipped with pins which make an electrical connection to the terminals of the battery by piercing the insulating outer casing of leads connected to the battery terminals. This eliminates the problems and costs associated with using a cable with a shielded ring to make the electrical connection directly to the battery terminal.

### Description of the Drawings

The following detailed description will be better understood when read in conjunction with the figures appended hereto. For the purpose of illustrating the invention, there is shown in the drawings a preferred embodiment. It is understood, however, that this invention is not limited to this embodiment or the precise arrangements shown.
Figure 1 is a top view of an industrial battery, showing individual cells connected serially to provide the total output voltage of the battery;
Figure 2 is a schematic illustration of an electrolyte level monitor in accordance with the present invention;
Figure 3 is a schematic illustration of the circuitry of the device in Fig. 2 to make the device polarity insensitive and to allow a single model to operate over a range of battery voltages;
Figure 3A is a schematic illustration of the device in Fig. 2 in combination with a battery in accordance with the present invention;
Figure 4 shows another monitoring device in accordance with the present invention;
Figure 5 is an enlarged view of the housing of the device shown in Fig. 4;
Figure 6 is an enlarged view of the housing shown in Fig. 5 with a section removed to show the internal circuitry schematically; and
Figure 7 is a top view of the housing shown in Fig. 5.

### Description of the Invention

Exemplary monitoring devices 38 in accordance with the present invention are now described with reference to the Figures appended hereto. The monitoring devices 38 can be any type of battery monitoring device that draws its power from the battery 10 being monitored, one preferable example being an electrolyte level monitor which is described below.

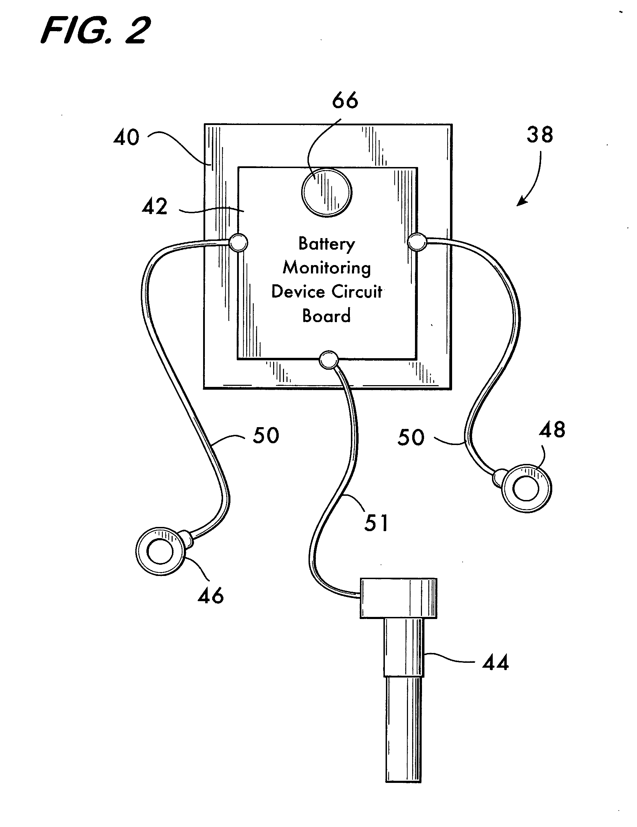

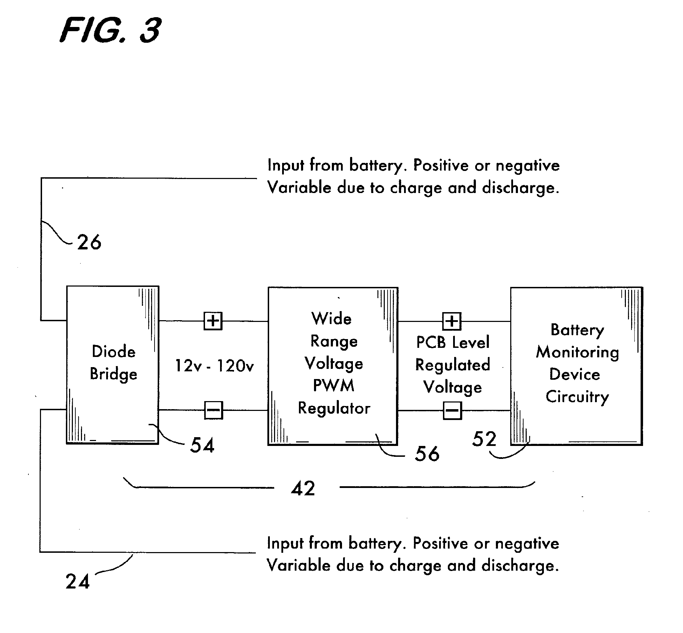

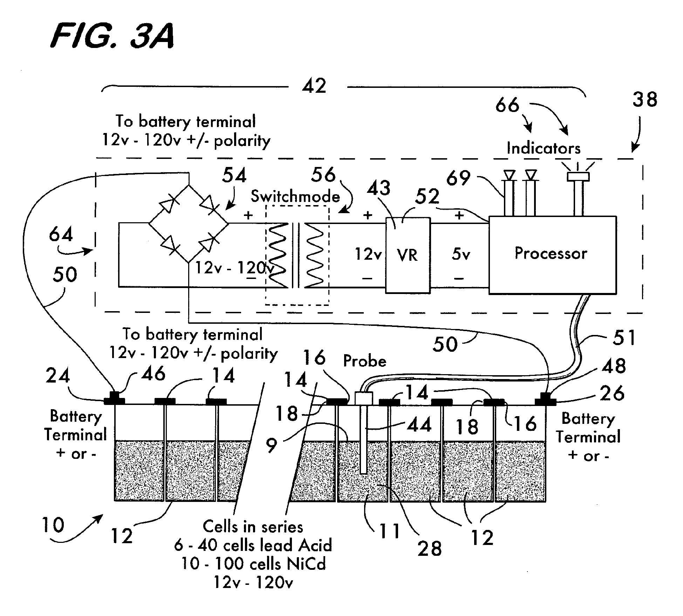

An exemplary electrolyte level monitor 38 for use with a battery as shown in Fig. 1 is now described with reference to Figs. 2, 3 and 3A. The device 38 includes a device housing 40 which includes the device circuitry 42 within, an electrolyte level probe 44 which is to be inserted into one of the cells 12 of the battery 10 (see Fig. 3A showing the probe 44 extending down from the top of the battery cell 28 into the electrolyte 11), and first and second terminal connectors 46, 48 for attachment to the monitored battery 10 for obtaining power therefrom. These device terminal connectors 46, 48 are not termed positive and negative connectors as they would be for prior art devices that are polarity sensitive, instead the device 38 is polarity insensitive as further discussed below. One or more indicators 66 (one shown), such as LEDs, are provided to indicate the status of the electrolyte. The various components are shown connected to one another via electrical wires 50 to the connectors 46, 48 and wire 51 to the probe 44, but other configurations are possible; for example, the housing could be combined with the probe 44, and or the electrical connectors 46, 48 could be combined with the housing 40 (such an embodiment is described below). Another example of an electrolyte level monitoring device is disclosed in U.S. Patent No. 7,812,613, which does not include the novel circuitry to be described herein, but which can be modified to include the novel circuitry which is now described with further reference to Figure 3. The disclosure of U.S. Patent No. 7,812,613 is incorporated herein by reference.

Figures 3 and 3A show schematically the improvements to the circuitry of the device 38. The circuitry 42 can include a conventional level monitoring circuit 52 such as that shown in U.S. Patent 7,812,613 or any other type monitoring circuit to operate the monitoring device 38 as known in the art and can include the conventional power regulator 43. The circuitry 42 further includes the polarity neutral feature 54 of the invention and may be, for example, implemented via any know method. In the preferred embodiment, a diode bridge circuit 54 is used. Although the typical use of a diode bridge is to rectify AC voltage into DC voltage out, the bridge will ensure that the polarity of the DC voltage produced by the battery is correct for the monitoring device 38. The output of the diode bridge 54 will be the DC voltage of the battery 10 having the correct polarity for the operation of the monitoring device 38.

The circuitry 42 additionally includes circuitry 56 to convert the total voltage inputted to a range suitable for the circuitry of the monitoring device circuits 52. This circuitry may be, for example, a switched-mode power supply using a wide-range pulse width modulation regulation method to provide the proper output voltage. Also known as a PWM regulator, in the present embodiment, such a circuit modulates the input voltage using a square wave having a variable duty cycle operating at about 25 kHz. The circuit components 52, 54 and 56 can be provided on a common circuit board, or as separate components.

The result of the implementation of the two circuitry improvements discussed above is a device which can be connected directly to the main terminals of a battery 10, e.g. terminals 24 and 26 in Figs. 1, 3A, regardless of the voltage of the battery which, in industrial settings, typically ranges from 12v to 80v, and may in some cases go as high as 120 volts, well beyond the capabilities of the conventional voltage regulators. The main terminals 24, 26 are clearly identifiable. This eliminates the burdensome installation procedure necessary with prior art batteries and allows for fool proof installation. The use of the diode bridge 54 and switch-mode power supply 56 circuit configurations in the context of an industrial battery monitor is heretofore unknown and solves long-recognized problems inherent in the art as discussed above. It is further appreciated that the diode bridge 54 and switch-mode power supply 56 circuits can be combined in a single device 38 as discussed above, or used separately with an individual device 38, e.g., the circuitry 42 could consist of the monitoring circuit 52 and the PWM circuit 56 without the diode bridge 54, or the circuit 42 could consist of the monitoring circuit 52 and the diode bridge circuit 54 without the PWM circuit 56.

The embodiment described above with reference to Fig. 2 is directed to a device 38 that is connectable to the main battery terminals 46, 48 for power via the metal ring connectors shown in Fig. 2. These ring connectors can be screwed to the terminals as known in the art.

A battery 10 in combination with the electrolyte monitoring device 38 as described above is now described with further reference to Figs. 1 and 3A. The device 38 is shown schematically with its probe 44 installed in cell 28 to monitor the level 9 of the electrolyte 11. The power is taken across the entire battery 10 at its full voltage of 48 volts, the wires 50 leading to respective battery terminals 24 and 26. The housing 40 of the device (see Fig. 2) includes the circuitry 42, preferably on a single circuit board 64 electrically connected to the wires 50 and 51.

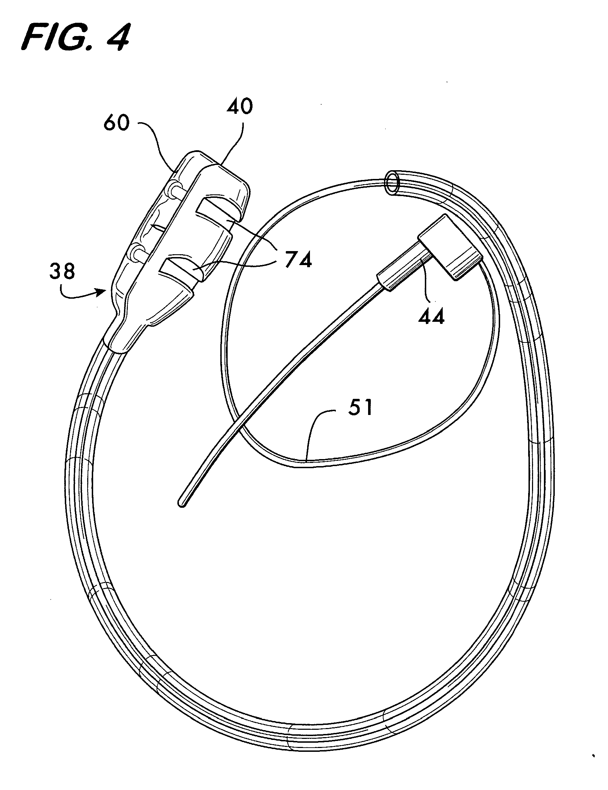

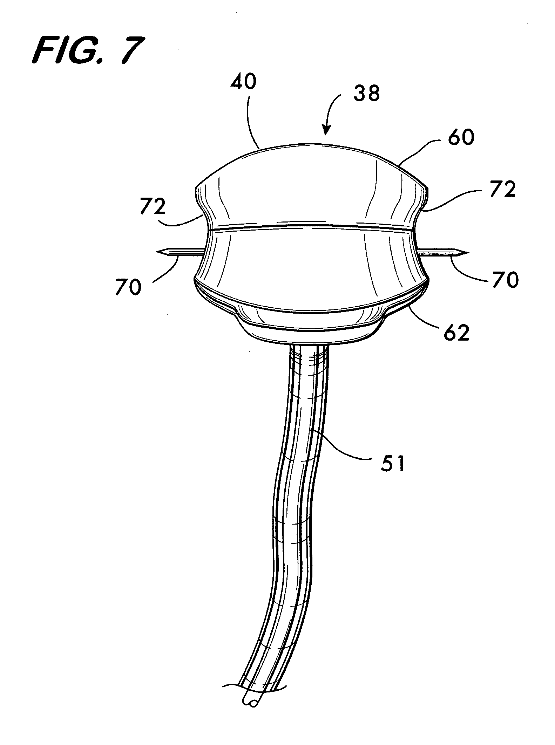

Another embodiment of the invention, similar to that shown in Fig. 2 but with a different means for connecting to the main battery terminals is now described with further reference to Figs 4, 5, 6 and 7. Similar to the device shown in Fig. 2, this device 38 includes a housing 40, circuitry 42 within the housing, and a probe 44 connected by wire 51 to the circuitry 42. The housing is formed of a front translucent section 60 to allow indicator lights 68 to be seen therethrough, and a back non-translucent section 62, both made of a suitable polymer. The two sections can be secured together with screws. Ultrasonic welding can also be used to seal the two halves to one another.

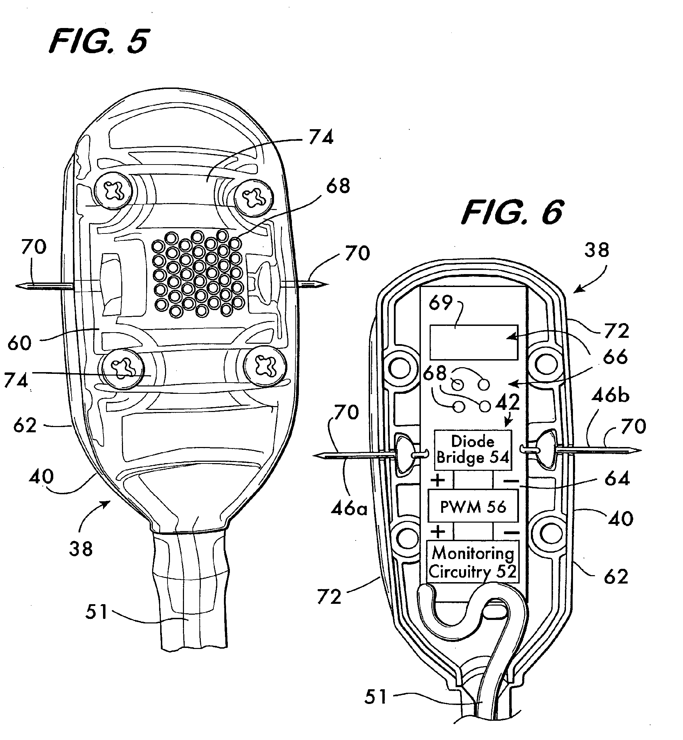

With further reference to Figs. 3 and 3A, the circuitry 42 includes a level monitoring circuit 52, a diode bridge circuit 54 to provide polarity neutrality, and a switched-mode power supply 56 using a wide-range pulse width modulation regulation method to provide the proper output voltage as discussed above with reference to Fig. 2. The circuit components 52, 54 and 56 are provided preferably on a common circuit board 64 as shown schematically in Figs. 3A and 6 which is connected electrically to the wires 50 and 51 for the power and probe 44.

The device also includes an indicator 66, preferably on the circuit board 64, to provide information related to the monitoring, e.g., the status of the electrolyte level. The indicator can be in the form of lights 68, which can be seen through the translucent section 60, such as LEDs, which can be lit in a manner to provide the desired information to users, such as by blinking, or use of different colors. For example, the device could provide a green signal when the level is OK and a red signal when the battery needs to have water added. The indicator 66 may also be an audible indicator 69 such as a beeper to provide an audible warning. For example, if the battery has been in need of water for one day, the device could beep once followed by a five second pause and repeat. The device would then beep once per second to indicate the number of days without water followed by a pause. This would increase the urgency to fill the battery and would also inform the user how long the battery had gone without water.

Here the electrolyte level monitor housing 40 has integrated, insulation piercing electrical connections 46a, 46b in the form of pins 70 protruding from the sides of the housing 72 as shown. The device can be mounted universally to the two main battery cables 20, 22 (Fig. 1) for electrical connection to the terminals 24, 26, rather than connected directly to the terminals. The act of making the electrical connection(s) using the pins 70 also mounts the device 38 to the battery 10. Additionally, the use of the pins 70 to make the electrical connection eliminates the cost of providing the cables having the ringed terminal connectors and the necessity of having the connection to the battery in the hostile environment where sulphuric acid or other corrosive liquids may cause standard off the shelf connectors to corrode.

The housing 40 has opposing sides 72 preferably curved to receive the circular battery cables 20, 22. As the cables are forced into the curved sides 72, the metal cable piercing electrical connection pins 70 pierce the insulation of the cable and make an electrical connection with the cable. If polarity neutral circuitry 54 is used, it does not matter which cable is connected to which pin. If polarity neutral circuitry 54 is not used, the cable connected to the positive side of the battery must be placed on the one side of the housing indicated for connection to the positive, and the cable connected to the negative battery terminal must be connected to the opposite side of the housing indicated for connection to the negative.

The cable piercing connections 70 are electrically connected to the circuitry 42 within the housing 40. Similarly, the electrolyte probe 44 is electrically connected to the circuitry 42 within the housing via a wire 51 which sealingly extends through the housing.

The housing 14 can be fitted with two or more transverse grooves 74 on the top and bottom surfaces thereof intended to accept cable ties, which hold the cables 22, 24 to the curved housing sides 72 and in contact with the insulation-piercing pins 70.

The benefits of this invention are numerous. First, the novel circuitry 42 allows a battery monitoring device 38 which is powered by the battery 10 being monitored to be installed in a fool proof manner without having to worry about the polarity of the connections and without worrying about choosing the proper number of cells for power. The device is able to be fitted to all batteries, thereby eliminating the need for a multiplicity of variations of the device, thus reducing stock numbers for manufacturers and distributors. The simpler installation will also lead to more widespread use and thereby improve the performance and maintenance of industrial batteries. The simplicity of the installation will result in reduced warranty costs as there will be less returned products that were damaged due to incorrect installations and quicker installation because counting cells is not required to connect it properly.

Second, the pin connector embodiment enables the elimination of up to two cables and their corresponding terminal connection hardware, which can reduce the cost of the overall device by as much as 50%.

It is appreciated that described above are novel apparatuses and methods. It is also understood that the invention is not limited to the embodiments and illustrations described above, and includes the full scope provided by the claims appended hereto.

## Claims

1. A device for monitoring the electrolyte level of a battery having multiple cells, comprising:
a) a housing;
b) a probe for insertion into a cell of said battery;
b) circuitry for monitoring said electrolyte level, said circuitry being electrically connected to said probe;
c) said circuitry including a circuit allowing said device to be powered by the total voltage of said battery;
d) said circuitry including a circuit making the device insensitive to the polarity of an input voltage; and
e) two electrical connectors for connection to the battery, said connectors being electrically connected to said circuitry.

2. The device of claim 1 wherein said circuit allowing said device to be powered by the total voltage of said battery comprises a switch mode power supply.

3. The device of claim 1 wherein said circuitry making the device insensitive to the polarity of an input voltage comprises a diode bridge.

4. The device of claim 2 wherein said circuitry making the device insensitive to the polarity of an input voltage comprises a diode bridge.

5. The device of claim 2 wherein said circuit allowing said device to be powered by the total voltage of said battery comprises a switch mode power supply using a wide-range pulse width modulation regulation method.

6. The device of claim 3 wherein said circuit allowing said device to be powered by the total voltage of said battery comprises a switch mode power supply using a wide-range pulse width modulation regulation method.

7. A device for monitoring the electrolyte level of a battery having multiple cells, comprising:
a) a housing;
b) a probe for insertion into a cell of said battery;
b) circuitry for monitoring said electrolyte level, said circuitry being electrically connected to said probe;
c) said circuitry including a circuit allowing said device to be powered by the total voltage of said battery; and
d) two electrical connectors for connection to the battery, said connectors being electrically connected to said circuitry.

8. The device of claim 7 wherein said circuit allowing said device to be powered by the total voltage of said battery comprises a switch mode power supply.

9. A device for monitoring the electrolyte level of a battery having multiple cells, comprising:
a) a housing;
b) a probe for insertion into a cell of said battery;
b) circuitry for monitoring said electrolyte level, said circuitry being electrically connected to said probe;
c) said circuitry including a circuit making the device insensitive to the polarity of an input voltage to said device; and
d) two electrical connectors for connection to the battery, said connectors being electrically connected to said circuitry.

10. The device of claim 9 wherein said circuitry making the device insensitive to the polarity of an input voltage comprises a diode bridge.

11. A battery, comprising:
a) multiple battery cells connected electrically in series;
b) a positive battery terminal connected to said cells;
c) a negative battery terminal connected to said cells; and
d) a monitoring device for monitoring the battery, said device comprising:
i. first and second connectors, one of said connectors electrically connected to said positive battery terminal, the other of said connectors electrically connected to said negative battery terminal;
ii. circuitry for monitoring said battery, said circuitry being electrically connected to said first and second connectors to receive power from said battery;
iii. said circuitry including a circuit allowing said device to be powered by the total voltage of said battery;
iv. said circuitry including a circuit making the device insensitive to the polarity of an input voltage.

12. The battery of claim 11, wherein said monitoring device comprises an electrolyte level monitoring device having a probe for insertion into one of said cells, said circuitry further including a circuit for monitoring said electrolyte level, said probe being electrically connected to said circuitry.

13. The battery of claim 12 wherein said circuit allowing said monitoring device to be powered by the total voltage of said battery comprises a switch mode power supply.

14. The battery of claim 12 wherein said circuit making the monitoring device insensitive to the polarity of an input voltage comprises a diode bridge.

15. The battery of claim 13 wherein said circuit making the monitoring device insensitive to the polarity of an input voltage comprises a diode bridge.

16. The battery of claim 11 wherein said monitoring device further comprises two insulation-piercing connectors electrically connected to said circuitry and configured to extend from a housing for said circuitry.

17. A battery, comprising:
a) multiple battery cells connected electrically in series, said cells having electrolyte therein, said electrolyte having a level;
b) a positive battery terminal connected to said cells;
c) a negative battery terminal connected to said cells; and
d) a device in accordance with claim 7 for monitoring the electrolyte level of the battery, one of said two electrical connectors being connected to said positive terminal, the other of said two electrical connectors being connected to said negative terminal.

18. A battery, comprising:
a) multiple battery cells connected electrically in series, said cells having electrolyte therein, said electrolyte having a level;
b) a positive battery terminal connected to said cells;
c) a negative battery terminal connected to said cells; and
d) a device in accordance with claim 9 for monitoring the electrolyte level of the battery, one of said two electrical connectors being connected to said positive terminal, the other of said two electrical connectors being connected to said negative terminal.

19. The device of claim 8 wherein said circuit allowing said device to be powered by the total voltage of said battery comprises a switch mode power supply using a wide-range pulse width modulation regulation method.

20. The device of claim 13 wherein said circuit allowing said device to be powered by the total voltage of said battery comprises a switch mode power supply using a wide-range pulse width modulation regulation method.
